# EUROPEAN PATENT APPLICATION

(11) **EP 2 907 890 A1**
(43) Date of publication of application: **19.08.2015**
(21) Application number: 13844848.5
(22) Date of filing: 06.09.2013
(51) Int. Cl.: C23C 14/32

(54) **PVD TREATMENT METHOD AND PVD TREATMENT DEVICE**

(30) Priority: 12.10.2012 JP 2012226766
(71) Applicant: Kabushiki Kaisha Kobe Seiko Sho (Kobe Steel, Ltd.), Kobe-shi, Hyogo 651-8585 (JP)
(72) Inventor: FUJII, Hirofumi, Takasago-shi, Hyogo 676-8670 (JP)
(74) Representative: TBK
(86) International application number: PCT/JP2013/005287
(87) International publication number: WO 2014/057608

(57) **Abstract**

Provided are a method and device that make it possible to perform PVD treatment with uneven target consumption reliably minimized. This PVD treatment method includes the following: performing PVD treatment by producing discharges between a positive electrode (3) and a negative electrode (4) inside a vacuum chamber (2) to vaporize the negative electrode (4); and during the PVD treatment, circulating a cooling medium through a cooling channel formed on either the positive electrode (3) or the negative electrode (4), i.e. the "cooled electrode", thereby cooling the cooled electrode, and reversing the circulation direction of the cooling medium.

## Description

### TECHNICAL FIELD

The present invention relates to a PVD treatment method and a PVD treatment device.

### BACKGROUND ART

For the purpose of improving wear resistance of cutting tools and sliding characteristics of the sliding surface of mechanical parts, a substrate (i.e. an object for film deposition) has been conventionally coated with a hard film (TiN, TiAIN, CrN, etc.) by a physical vapor deposition (PVD) method. Devices used for the deposition of the hard film include film deposition devices such as an arc ion plating device and a sputtering device.

Patent Document 1, for example, discloses an arc ion plating device comprising a target constituting a negative electrode, and a positive electrode. The target is formed in a rod shape oriented in the vertical direction. The positive electrode is arranged around the target so as to surround the target. Specifically, the positive electrode comprises an upper ring-shaped electrode disposed above the upper end of the target toward outside the outer periphery with a distance, a lower ring-shaped electrode disposed below the lower end of the negative electrode toward outside the outer periphery with a distance, and a plurality of rod-shaped electrodes connecting these upper and lower ring-shaped electrodes in the vertical direction.

On the other hand, it is known that, in a conventional PVD treatment device, if there is unevenness in the surface temperature of the target, i.e. the negative electrode, or in the surface temperature of the positive electrode generating discharges with the target, the electrical resistance eventually becomes relatively high in a high-temperature portion, thereby generating discharges preferentially only in a low-temperature portion, and as such, discharges are not uniformly generated in an electrode plane. Such uneven distribution of discharges is likely to cause uneven consumption of the target, where the target is locally consumed by discharges generated only in the portion of the electrode. Such uneven consumption in turn reduces the utilization efficiency of the target as well as shortens a service life of the target, resulting in an increase in the frequency of replacement work and the disposal cost of the target. Further, the uneven consumption of the target causes variation, deterioration in reproducibility, and the like in the film thickness distribution of a work.

Therefore, in the PVD treatment device according to Patent Document 1 described above, the electrode constituting the positive electrode and the target constituting the negative electrode are preferably cooled as uniformly as possible. For this purpose, Patent Document 1 discloses a configuration in which an inner part of the target is hollowed to constitute a cooling channel, through which a cooling water can circulate.

However, in practice, circulating the cooling water through the cooling channel causes a large difference in the temperature of the cooling water between the inlet side and the outlet side of the channel. This temperature difference generates a difference in the cooling capacity and may cause the uneven consumption of the target. For example, the cooling capacity is high near the inlet side of the cooling channel because of the cooling water having the lower temperature, resulting in locally lowering the electrode temperature and promoting discharges. On the other hand, the cooling capacity is low near the outlet side of the cooling channel because of the cooling water having the higher temperature, resulting in increasing the electrode temperature and suppressing discharges. Consequently, the uneven consumption of the target occurs. In conclusion, the conventional PVD treatment device, due to the partially insufficient cooling in the electrode, has been unable to reliably suppress the uneven consumption of the target.

### CITATION LIST

### PATENT DOCUMENT

Patent Document 1: Japanese Patent No. 3195492

### SUMMARY OF THE INVENTION

An object of the present invention is to provide a PVD treatment method and a PVD treatment device capable of performing a PVD treatment with uneven target consumption reliably minimized.

A PVD treatment method provided by the present invention comprises: preparing a PVD treatment device, which includes a vacuum chamber internally kept in vacuum, and a positive electrode and a negative electrode disposed inside of the vacuum chamber, and has at least a part of a cooling channel formed in at least either of the positive electrode or the negative electrode, i.e. the cooled electrode; performing the PVD treatment by producing discharges between the positive electrode and the negative electrode to vaporize the negative electrode; during the PVD treatment, cooling the cooled electrode by circulating a cooling medium through the cooling channel; and reversing the circulation direction of the cooling medium.

Further, a PVD treatment device provided by the present invention includes: a vacuum chamber internally kept in vacuum; a positive electrode and a negative electrode disposed inside of the vacuum chamber, capable of performing a PVD treatment by producing discharges between the positive electrode and the negative electrode to vaporize the negative electrode; and a cooling mechanism for cooling at least either of the positive electrode or the negative electrode, i.e. the cooled electrode, wherein the cooling mechanism includes a cooling channel having a channel formed in the cooled electrode, through the inside of which a cooling medium can circulate for cooling the cooled electrode, and a circulation direction switching unit for alternately reversing the circulation direction of the cooling medium in the cooling channel.

### BRIEF DESCRIPTION OF DRAWINGS

[Fig. 1] Fig. 1 is a cross-sectional front view of the entire configuration of a PVD treatment device according to each embodiment of the present invention.
[Fig. 2] Fig. 2 is a perspective view of a target according to each embodiment of the present invention.
[Fig. 3] Fig. 3 is a flow sheet showing a cooling mechanism according to each embodiment of the present invention.
[Fig. 4] Fig. 4 is a perspective view of a cooling mechanism for cooling a target in a first embodiment of the present invention.
[Fig. 5] Fig. 5 is a perspective view of a cooling mechanism for cooling an outer electrode in a second embodiment of the present invention.
[Fig. 6] Fig. 6 is a view of a cooling mechanism for cooling an outer electrode provided in a PVD treatment device according to a reference example.

### DESCRIPTION OF EMBODIMENTS

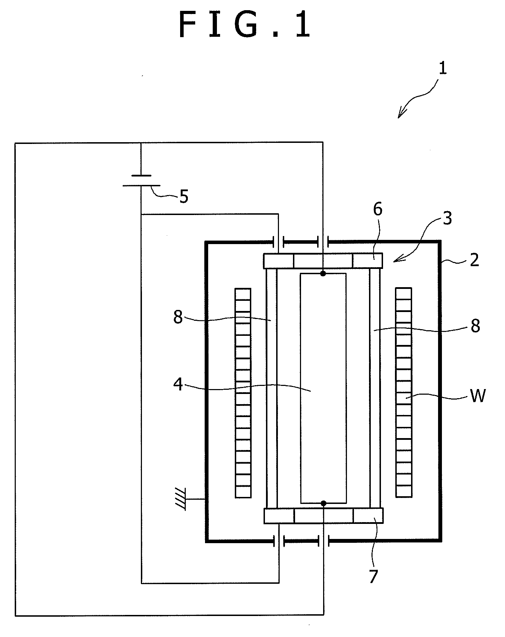

Fig. 1 shows the entire configuration of a PVD treatment device 1 according to each embodiment of the present invention described as follows. The PVD treatment device 1 is a device that performs film formation on the surface of a work W by utilizing a PVD (Physical Vapor Deposition) method. The PVD method is a method for forming a film by depositing a film forming material on the work W through a physical means in which the film forming material is, for example, vaporized by an arc or sprung out by ion collision.

The PVD treatment device carrying out the PVD method includes an AIP device (Arc Ion Plating) for forming a film by an arc ion plating method, a sputtering device and the like. Bearing the AIP device in mind, the PVD treatment device 1 according to embodiments of the present invention will be described below. It should be noted in the descriptions below that, between electrodes used in the PVD treatment, an electrode having higher electric potential is referred to as a "positive electrode", while an electrode having lower electric potential is referred to as a "negative electrode", and these terms are synonymous with an anode and a cathode, respectively.

As shown in Fig. 1, the PVD treatment device 1 according to the embodiments of the present invention includes a vacuum chamber 2 with a hollow inside, an outer electrode 3 disposed inside of the vacuum chamber 2, and a target 4 similarly disposed inside of the vacuum chamber 2. Among them, the target 4 constitutes the negative electrode, while the "outer electrode 3" constitutes the positive electrode. That is, the target 4 and the outer electrode 3 are each used as electrodes for the PVD treatment.

The outer electrode 3 used as the positive electrode, i.e. anode, is connected to a plus pole of an arc power supply 5 shown as a DC power supply in Fig. 1, and the target 4 used as the negative electrode, i.e. cathode, is electrically connected to a minus pole of the arc power supply 5. The arc power supply 5 provides a potential difference capable of generating arc discharges between the outer electrode 3, i.e. the positive electrode and the target 4, i.e. the negative electrode.

A work W, i.e. an object for film formation, is arranged outside the outer electrode 3, so that a film forming material composed of the target 4 evaporated by the arc discharges described above, is deposited on the surface of the work W for forming a film.

The target 4 used as the negative electrode is a lengthy columnar member and disposed in the center of the vacuum chamber 2 so as to extend in the vertical direction, wherein appropriate parts of the target 4, for example, both the upper and lower ends of the target 4, are connected to the minus pole of the arc power supply 5 described above. The target 4 is composed of the film forming material to be deposited on the surface of the work W for forming a film. Specifically, as a material constituting the target 4, metals such as Ti, Zr, and Cr are preferable. By using these metals, hard films such as TiN, ZrN, and CrN can be formed on the surface of the work W.

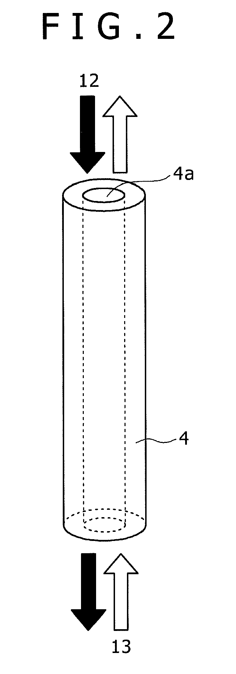

As shown in Fig. 2, the target 4 is formed in a hollow shape, i.e. a cylindrical shape. Specifically, the target 4 has a hollow part 4a along its axis and a cooling medium can circulate through the hollow part 4a.

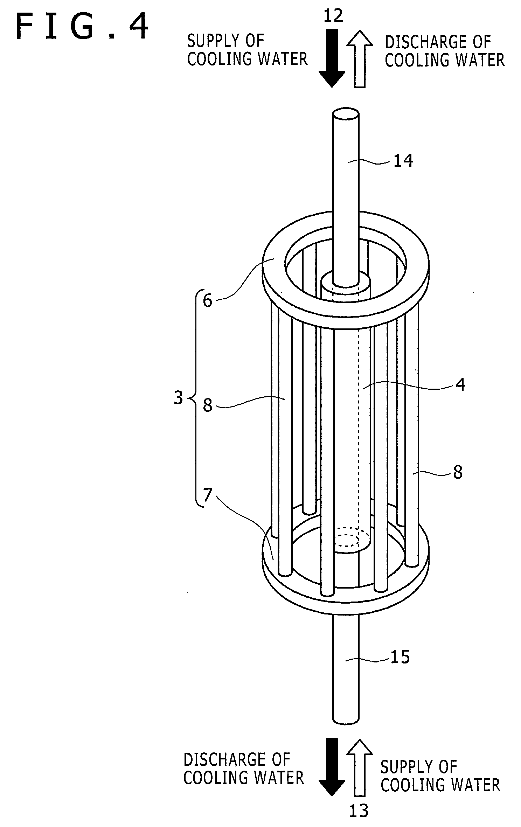

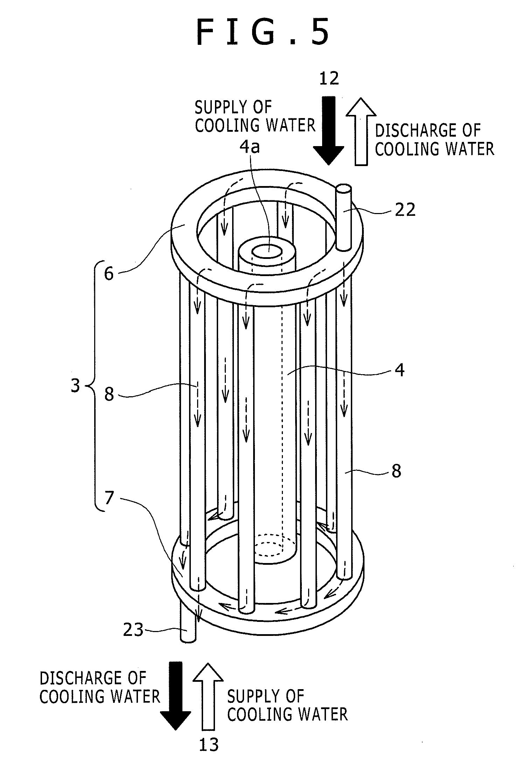

As shown in Fig. 4 and Fig. 5, the outer electrode 3 used as the positive electrode is arranged outside the target 4 in a cylindrical basket-like shape so as to surround the target 4. Specifically, the outer electrode 3 includes an upper ring-shaped electrode 6 disposed above the upper end of the target 4 with a distance towards outside in the radial direction of the target 4, a lower ring-shaped electrode 7 disposed below the lower end of the target 4 with a distance towards outside in the radial direction of the target 4, and a plurality of rod-shaped electrodes 8 connecting these upper ring-shaped electrode 6 and lower ring-shaped electrode 7 in the vertical direction.

The upper ring-shaped electrode 6 and the lower ring-shaped electrode 7 are electrodes formed in a circular shape around an axis in the vertical direction, i.e. in a shape embracing a circular space in the center. Each of the rod-shaped electrodes 8 is a bar-shaped electrode extending in the vertical direction and arranged around the target 4. Specifically, the rod-shaped electrodes 8 are each arrayed in plural positions (eight in the figure) at equal intervals in the circumferential direction so as to annularly surround the target 4. A hollow part is also formed in each rod-shaped electrode 8 along its axis.

In the PVD treatment device 1, if there is unevenness in the temperature of a discharge plane of the target 4 or a discharge plane of the outer electrode 3 generating discharges with the target 4, electrical resistance increases in a high-temperature portion, thereby generating discharges preferentially in a low-temperature portion, and consequently discharges may not be uniformly generated in the electrode planes. Such uneven distribution of discharges is likely to cause uneven consumption of the target 4, where the target 4 is locally consumed by discharges generated only in the portion of the target 4. As a means for suppressing the uneven consumption, as descried above, it is effective to circulate a cooling medium inside of the outer electrode 3 and the target 4 to cool the outer electrode 3 and the target 4. As such a cooling medium, a cooling water available at a low cost is preferable.

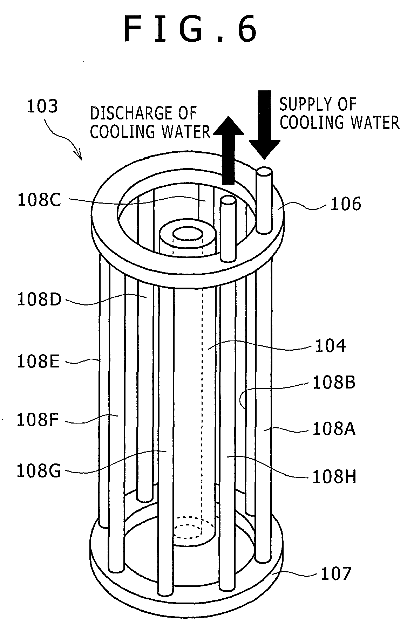

However, since the outer electrode 3 and the target 4 mentioned above, especially the outer electrode 3, have a very complicated structure, a sufficient cooling effect may not be obtained simply by circulating the cooling water inside of them. The reason for the above will be described in details by referring to a device shown in Fig. 6 as a reference example.

The device shown in Fig. 6 includes a target 104 and an electrode 103, which is a positive electrode. The electrode 103 includes an upper ring-shaped hollow electrode 106, a lower ring-shaped hollow electrode 107, and eight rod-shaped hollow electrodes 108A, 108B, 108C, 108D, 108E, 108F, 108G, and 108H surrounding the target 104. The internal space of the upper ring-shaped electrode 106 and the lower ring-shaped electrode 107 is partitioned into a plurality of rooms arranged in the circumferential direction, and the two rod-shaped electrodes adjacent to each other are connected in each partitioned room. In this device, the cooling water is supplied to one of the rooms partitioned from one another in the upper ring-shaped electrode 106, and circulates inside of the electrode 103 while meandering through the rod-shaped electrode 108A, the lower ring-shaped electrode 107, the rod-shaped electrode 108B, the upper ring-shaped electrode 106, the rod-shaped electrode 108C, the lower ring-shaped electrode 107, the rod-shaped electrode 108D, the upper ring-shaped electrode 106, the rod-shaped electrode 108E, the lower ring-shaped electrode 107, the rod-shaped electrode 108F, the upper ring-shaped electrode 106, the rod-shaped electrode 108G, the lower ring-shaped electrode 107, and the rod-shaped electrode 108H in this order, thereby cooling the electrode 103, i.e. the positive electrode.

However, in practice, circulating the cooling water through the cooling channel causes a large difference in the temperature of the cooling water between the inlet side and the outlet side of the channel. This temperature difference between the inlet side and the outlet side generates a difference in the cooling capacity as well as a bias in the discharge state, and may eventually cause uneven consumption of the target 104. For example, the cooling capacity is high at the inlet side of the above-mentioned cooling channel in Fig. 6 because of the cooling water having the lower temperature, resulting in locally lowering the temperature of the electrodes near the inlet side, such as the rod-shaped electrode 108A and the rod-shaped electrode 108B, and promoting discharges. On the other hand, the cooling capacity is low near the outlet side of the cooling channel because of the cooling water having the higher temperature, resulting in increasing the temperature of the electrodes near the outlet side, such as the rod-shaped electrode 108G and the rod-shaped electrode 108H, and suppressing discharges. As the result, a problem of the uneven consumption occurs, in which a part of the target 104 near the rod-shaped electrodes 108A and 108B is largely recessed as compared with other parts.

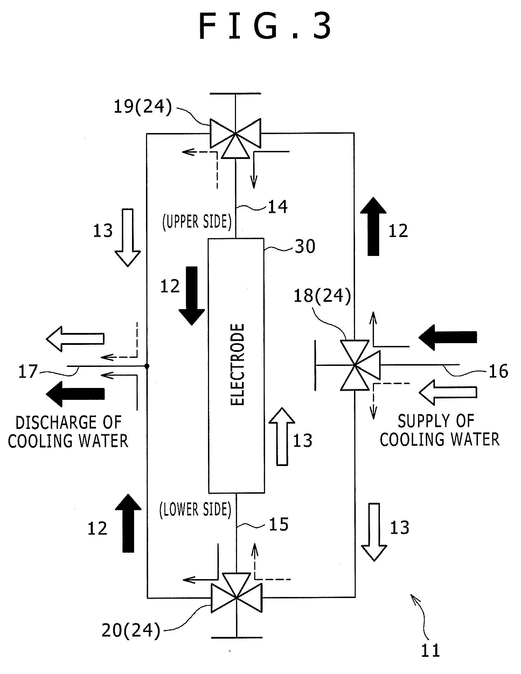

In regard to the above, a PVD treatment device 1 according to each embodiment of the present invention includes a cooling mechanism as shown in Fig. 3. This cooling mechanism is intended to cool at least either of the outer electrode 3 or the target 4, i.e. the cooled electrode 30, and includes a cooling channel 11 for cooling the cooled electrode 30 by circulating a cooling water, which serves as a cooling medium, through the cooled electrode 30, and a circulation direction switching unit 24 for repeatedly reversing the circulation direction of the cooling water in the cooling channel 11. The cooling channel 11 comprises a first cooling channel 12 for cooling the electrode by circulating the cooling water from the one side to the other side of the electrode, and a second cooling channel 13 for cooling the electrode by circulating the cooling water from the other side to the one side of the electrode.

The first cooling channel 12 and the second cooling channel 13 described herein may be physically and mutually independent channels, or alternatively, a common channel may serve as both the first cooling channel 12 and the second cooling channel 13. That is, because the "first cooling channel 12" is defined as a channel through which the cooling water flows from the one side to the other side of the cooled electrode 30, and the "second cooling channel 13" is defined as a channel through which the cooling water flows from the other side to the one side of the electrode, the common channel can be used in place of the first cooling channel 12 and the second cooling channel 13 provided that the flow direction of the cooling water can be reversed.

In the first and second embodiments, a channel formed inside of the cooled electrode 30 serves as both the first cooling channel 12 and the second cooling channel in the cooling channel 11. Switching the circulation direction of the cooling water, i.e. switching the channel for use between the first cooling channel 12 and the second cooling channel 13, is performed through the operation of the circulation direction switching unit 24.

The cooled electrode 30 cooled by the cooling mechanism may be one or both of the outer electrode 3 and the target 4. In the first embodiment, the target 4 formed in a lengthy columnar shape is cooled as the cooled electrode 30, while, in the second embodiment, the outer electrode 3 disposed outside the target 4 is cooled as the cooled electrode 30.

A cooling mechanism shown in Fig. 3 includes an upper pipe 14 connected to the upper end of the cooled electrode 30 (corresponding to the upper end of the target 4 in the first embodiment as shown in Fig. 4), a lower pipe 15 connected to the lower end of the cooled electrode 30 (corresponding to the lower end of the target 4 in the first embodiment as shown in Fig. 4), a supply pipe 16, a drainage pipe 17, and a plurality of switching valves 18, 19 and 20, respectively corresponding to a first, second and third valve, constituting a circulation direction switching unit 24. The upper pipe 14 and the lower pipe 15 are communicated with an inner part of the cooled electrode 30 (corresponding to the hollow part 4a in the target 4 in the first embodiment). The supply pipe 16 is connected to a cooling water supply unit not illustrated, and the drainage pipe 17 is connected to a cooling water drainage unit not illustrated.

The first to third switching valves 18 to 20 are each constituted with a three-way valve. The supply pipe 16 includes a portion from the cooling water supply unit to the first switching valve 18, and portions branched from the first switching valve 18 and constituting the first and second cooling channels 12 and 13.

A portion of the supply pipe 16 branched from the first switching valve 18 and constituting the first cooling channel 12 is connected to the upper pipe 14 via the second switching valve 19. Another port of the second switching valve 19 constituted with the three-way valve is connected to the drainage pipe 17 extending to the drainage unit for the cooling water.

A portion of the supply pipe 16 branched from the first switching valve 18 and constituting the second cooling channel 13 is connected to the lower pipe 15 via the third switching valve 20. Another port of the third switching valve 20 constituted with the three-way valve is connected to the drainage pipe 17 extending to the drainage unit for the cooling water.

The above-mentioned upper pipe 14, lower pipe 15, supply pipe 16, and drainage pipe 17 constitute the cooling channel 11, and the first to third switching valves 18 to 20 constitute the circulation direction switching unit 24 for reversing the circulation direction in the midway of the cooling channel 11. Thus, through the switching operation of the first to third switching valves 18 to 20, the circulation direction of the cooling water in the outer electrode 3 or the target 4, i.e. the cooled electrode 30 can be reversed. That is, the first cooling channel 12 and the second cooling channel 13 can be switched between each other.

Specifically, when the first cooling channel 12 is used, as shown by black arrows in Fig. 3, the first switching valve 18 is operated to guide the cooling water that flows through the supply pipe 16 to the second switching valve 19, the second switching valve 19 is operated to connect the supply pipe 16 to the upper pipe 14, and the third switching valve 20 is operated to connect the lower pipe 15 to the drainage pipe 17. In this way, the cooling water flowing through the upper pipe 14 flows down the channel formed inside of the cooled electrode 30 (corresponding to the hollow part 4a in the target 4 in the first embodiment), flows out into the lower pipe 15, and is led to the drainage pipe 17 via the third switching valve 20. Thus, the cooling water flowing through the first cooling channel 12 flows inside of the cooled electrode 30 from the upper side toward the lower side, i.e. in the downward direction, thereby cooling the cooled electrode 30.

On the other hand, when the second cooling channel 13 is used, as shown by void arrows in Fig. 3, the first switching valves 18 is operated to guide the cooling water that flows through the supply pipe 16 to the third switching valve 20, the third switching valve 20 is operated to connect the supply pipe 16 to the lower pipe 15, and the second switching valve 19 is operated to connect the upper pipe 14 to the drainage pipe 17. In this way, the cooling water flowing through the lower pipe 15 flows up the channel formed inside of the cooled electrode 30 (corresponding to the hollow part 4a in the target 4 in the first embodiment), flows out into the upper pipe 14, and is led to the drainage pipe 17 via the second switching valve 19. Thus, the cooling water flowing through the second cooling channel 13 flows inside of the cooled electrode 30 from the lower side toward the upper side, i.e. in the upward direction, thereby cooling the cooled electrode 30.

When the first cooling channel 12 is used, the upper part of the cooling channel 11 close to the inlet of the cooling water is more efficiently cooled than the lower part, while when the second cooling channel 13 is used, the lower part of the cooling channel 11 close to the outlet of the cooling water is more efficiently cooled than the upper part. Thus, the cooled electrode 30 can be uniformly cooled by reversing the flow direction of the cooling water in such a way as to use alternately the first cooling channel 12 and the second cooling channel 13. This operation equalizes consumption rate of the target 4, thereby enabling to improve the utilizing efficiency of the target 4 and extend the exchange period of the target 4. Further, this operation reduces the possibility of abnormal discharges caused by concentrated discharges and the like in the target 4, and can realize a work W having a uniform film thickness distribution.

In the embodiments, arc discharges are generated between the positive electrode and the negative electrode, however, the same electrode cooling mechanism can be applied to the case where sputter discharges are generated instead of the arc discharges.

The timing of reversing the circulation direction of the cooling water in the cooling channel 11 may be suitably selected in accordance with the content of the PVD treatment and the like.

For example, when the PVD treatment is performed by a batch treatment, it is preferable to switch the cooling channel for use between the first cooling channel 12 and the second cooling channel 13 for each batch, i.e. reverse the circulation direction of the cooling water either in the outer electrode 3 or the target 4. For example, the first to third switching valves 18 to 20 are preferably operated so as to use the first cooling channel 12 for the odd-number-ths batches and use the second cooling channel 13 for the even-number-ths batches.

Further, when a service life of the target 4, i.e. the negative electrode is previously known or can be estimated, it is preferable to divide the service life of the target 4 into a plurality of periods (e.g., two periods) and switch the cooling channel for use between the first cooling channel 12 and the second cooling channel 13 for each period, i.e. reverse the flow direction of the cooling water either in the outer electrode 3 or the target 4. For example, the first to third switching valves 18 to 20 are preferably operated so as to use the first cooling channel 12 for the first period and use the second cooling channel 13 for the second period. The service life of the target 4 can be estimated from integrated values of discharge current and discharge power for an arc electrode and a sputter electrode, respectively.

In this way, it becomes possible to perform the PVD treatment while reliably minimizing the uneven consumption of the target 4. For example, discharge of droplets (molten particles) from the target 4 is inevitable in the arc ion plating method, and it is known that the number and size of the droplets sharply increase with a temperature rise in the target 4. However, such increase of the droplets can be prevented by uniformly cooling the target 4. Further, both in the arc ion plating method and the sputtering method, temperature unevenness in the target 4 may cause uneven deformation of the target, thereby further increasing the temperature unevenness, or generating a crack if a fragile material is used. However, such defects can be prevented by uniformly cooling the target 4 using techniques according to the first embodiment.

The cooling mechanism according to the first embodiment directly cool the target 4, i.e. the negative electrode, however, the cooling mechanism according to the second embodiment can also indirectly cool the target 4 by cooling the outer electrode 3, i.e. the positive electrode, to prevent the consumption of the outer electrode 3 itself. Further, in the second embodiment, the cooling mechanism suppresses the temperature unevenness in the discharge plane of the outer electrode 3 using the cooling mechanism, thus enabling to generate arcs between both electrodes more uniformly and minimize the uneven consumption of the target 4 further reliably.

A main part of the PVD treatment device according to the second embodiment is shown in Fig. 5. The cooling channel 11 of the cooling mechanism according to the second embodiment circulates the cooling water inside of the outer electrode 3. The outer electrode 3, as mentioned above, includes the upper ring-shaped electrode 6, the lower ring-shaped electrode 7, and the plurality of rod-shaped electrodes 8, and these electrodes 6 to 8 all have a hollow structure for allowing the cooling water to circulate. Furthermore, unlike the device shown in Fig. 6, the insides of the upper ring-shaped electrode 106 and the lower ring-shaped electrode 107 are not partitioned into a plurality of rooms. Therefore, when the cooling water is poured into the upper ring-shaped electrode 106, the cooling water circulates the entire inside of the upper ring-shaped electrode 106, flows down equally through each of the rod-shaped electrodes 8 extending vertically, and flows into the inside of the lower ring-shaped electrode 7. That is, in the cooling mechanism according to the second embodiment, the cooling channel 11 is branched to a plurality of branched channels, i.e. the channels inside of each of the rod-shaped electrodes 8, within the outer electrode 3, i.e. the cooled electrode 30, and the cooling water flows so as to be equally distributed into each branched channel.

Described more specifically, in the cooling mechanism according to the second embodiment, a channel formed inside of the upper ring-shaped electrode 6 in the cooling channel 11 forms a ring-like shape continuing in the circumferential direction of the upper ring-shaped electrode 6. An upper connection pipe 22 for supplying and discharging the cooling water into the upper ring-shaped electrode 6 is provided on the upper wall of the upper ring-shaped electrode 6. Each of the rod-shaped electrodes 8 is connected to the bottom wall of the upper ring-shaped electrode 6 while being arranged at equal intervals in the circumferential direction. Thus, when the cooling water is supplied to the channel in the ring-like shape inside of the upper ring-shaped electrode 6, the cooling water is distributed into the branched channels inside of the corresponding rod-shaped electrodes 8. Conversely, when the cooling water is distributed into the branched channels inside of the corresponding rod-shaped electrodes 8 at the lower side, and flows up through the branched channels, the cooling water is converged in the channel in the ring-like shape inside of the upper ring-shaped electrode 6.

The lower ring-shaped electrode 7 has a structure in which the upper ring-shaped electrode 6 is turned upside down. That is, the lower ring-shaped electrode 7 also includes therein a ring-like shape channel, and each of the rod-shaped electrodes 8 is connected to the top wall of the lower ring-shaped electrode 7 while being arranged at equal intervals in the circumferential direction. Therefore, the channel inside of the lower ring-shaped electrode 7 makes it possible to distribute the cooling water into each of the rod-shaped electrode 8 in the lower part of the corresponding rod-shaped electrodes 8, or conversely converge the cooling water that flows down each of the rod-shaped electrode 8 after being distributed in the upper part of the corresponding rod-shaped electrodes 8. A lower connection pipe 23 for supplying and discharging the cooling water into the lower ring-shaped electrode 7 is provided on the bottom wall of the lower ring-shaped electrode 7.

The internal channel of the outer electrode 3 having such structure, like the hollow part 4a in the target 4 according to the first embodiment, can also be integrated into a piping route such as the one shown in Fig. 3. In this case, the upper connection pipe 22 is connected to the upper pipe 14 extending from the second switching valve 19, and the lower connection pipe 23 is connected to the lower pipe 15 extending to the third switching valve 20. Through the switching operation of the first to third switching valves 18 to 20 constituting the circulation direction switching unit 24, the channel for use can be switched between the first cooling channel 12 and the second cooling channel 13. For example, when the cooling water flows through the first cooling channel 12, the cooling water supplied into the upper ring-shaped electrode 6 is distributed into the branched channels inside of each of the rod-shaped electrodes 8, flows down the branched channels, and then is converged into the lower ring-shaped electrode 7, thereby reliably cooling the outer electrode 3. Conversely, when the cooling water flows through the second cooling channel 13, the cooling water supplied into the lower ring-shaped electrode 7 is distributed into the branched channels inside of each of the rod-shaped electrodes 8, flows up the branched channels, and then is converged into the upper ring-shaped electrode 6, thereby reliably cooling the outer electrode 3.

Thus, in the second embodiment, similarly in the first embodiment, the outer electrode 3 can be cooled in the same manner as the target 4 according to the first embodiment is cooled, by alternately switching between the first cooling channel 12 and the second cooling channel 13 with the use of the circulation direction switching unit 24 shown in Fig. 3. The lower connection pipe 23 provided with the lower ring-shaped electrode 7 is further preferably arranged on the opposite side of the upper connection pipe 22 provided with the upper ring-shaped electrode 6 across the center of the rings. That is, the cooling channels formed inside of the outer electrode 3 are preferably arranged so as to be symmetrical in the vertical direction as well as the lateral direction. This arrangement makes it possible to substantially uniformize a flow of cooling water between the cases where the first cooling channel 12 is used, i.e. the cooling water flows from the upper ring-shaped electrode 6 to the lower ring-shaped electrode 7, and the case where the second cooling channel 13 is used, i.e. the cooling water flows from the lower ring-shaped electrode 7 to the upper ring-shaped electrode 6, thus enabling to equalize a flow rate of the cooling water in the cooling channel 11.

Other configurations of the second embodiment are substantially the same as those of the first embodiment, and detailed descriptions thereof will be omitted.

Using the techniques in the second embodiment described above makes it possible to indirectly cool the target 4 while preventing the consumption of the outer electrode 3 itself, and perform the PVD treatment while reliably minimizing the uneven consumption of the target 4.

Further, as shown in Fig. 1, the discharge plane of the positive electrode constituted of the outer electrode 3 is usually disposed closer to the work W than the discharge plane of the negative electrode constituted of the target 4, thus the temperature of the work W in processing is more likely to be affected by the temperature of the outer electrode 3. Since variations of the temperature of the work in processing affect the quality of films, equalizing the temperature of the outer electrode 3 contributes to uniformize the quality of the films to a high degree.

The present invention is not limited to each embodiment, and shapes, structures, materials, combinations, and the like of each member may be appropriately changed so long as the invention is not changed in essence. Further, in the embodiments disclosed herein, the matters that are not explicitly disclosed, for example, operation conditions, various parameters, the size, weight, and volume of structural materials, and the like, do not deviate from the range in which a person skilled in the art usually practices the invention, and the matters that can be readily perceived by an ordinary person skilled in the art are employed.

As described above, according to the present invention, provided are a PVD treatment method and a PVD treatment device that make it possible to perform a PVD treatment with uneven target consumption reliably minimized.

A PVD treatment method provided by the present invention comprises: preparing a PVD treatment device, which includes a vacuum chamber internally kept in vacuum, and a positive electrode and a negative electrode disposed inside of the vacuum chamber, and has at least a part of a cooling channel formed in at least either of the positive electrode or the negative electrode, i.e. the cooled electrode; performing the PVD treatment by producing discharges between the positive electrode and the negative electrode to vaporize the negative electrode; during the PVD treatment, cooling the cooled electrode by circulating a cooling medium through the cooling channel; and reversing the circulation direction of the cooling medium. Reversing the circulation direction in this way makes it possible to uniformly cool the cooled electrode and reliably minimize the uneven target consumption.

In this method, it is preferable that, in the PVD treatment device, the cooling channel disposed in the cooled electrode is branched to a plurality of branched channels, and the cooled electrode is cooled by a flow of the cooling medium distributed into each of the plurality of branched channels. Such distribution of the cooling medium into each branched channel makes it possible to cool the cooled electrode further uniformly.

The PVD treatment may be performed by a batch treatment. In this case, it is preferable to reverse the circulation direction of the cooling medium in the cooling channel, for example, for each batch treatment.

Alternatively, it may be possible to divide a service life of the negative electrode into a plurality of periods and reverse the circulation direction of the cooling medium in the cooling channel for each period.

Further, a PVD treatment device provided by the present invention includes: a vacuum chamber internally kept in vacuum; a positive electrode and a negative electrode disposed inside of the vacuum chamber, capable of performing a PVD treatment by producing discharges between the positive electrode and the negative electrode to vaporize the negative electrode; and a cooling mechanism for cooling at least either of the positive electrode or the negative electrode, i.e. the cooled electrode. The cooling mechanism includes a cooling channel having a channel formed in the cooled electrode, through the inside of which a cooling medium can circulate for cooling the cooled electrode, and a circulation direction switching unit for alternately reversing the circulation direction of the cooling medium in the cooling channel.

For example, it is preferable that the cooling channel comprises a first cooling channel for cooling the cooled electrode by circulating the cooling medium from the one side to the other side of the cooled electrode, and a second cooling channel for cooling the electrode by circulating the cooling medium from the other side to the one side of the electrode, and that the circulation direction switching unit switches between the first cooling channel and the second cooling channel for the cooling medium to circulate.

In the case where at least the positive electrode is the cooled electrode between the positive electrode and the negative electrode, and the negative electrode is formed in a cylindrical shape extending in the vertical direction, it is preferable that the positive electrode includes an upper ring-shaped electrode disposed above the upper end of the negative electrode with a distance towards outside in the radial direction of the negative electrode, a lower ring-shaped electrode disposed below the lower end of the negative electrode with a distance towards outside in the radial direction of the negative electrode, and a plurality of rod-shaped electrodes connecting the upper ring-shaped electrode and lower ring-shaped electrode in the vertical direction, and that the cooling channel includes an upper hollow part in a ring shape formed inside of the upper ring-shaped electrode, a lower hollow part in a ring shape formed inside of the lower ring-shaped electrode, and a plurality of middle hollow parts formed along the axis of each of the rod-shaped electrodes to communicate the upper hollow part and the lower hollow part. Such structure built in the positive electrode allows the positive electrode to function as an outer electrode for generating discharges with the negative electrode disposed inside of the positive electrode, and simultaneously makes it possible to form the channels for the cooling medium to circulate between the upper ring-shaped electrode and the lower ring-shaped electrode.

## Claims

1. A PVD treatment method comprising:
preparing a PVD treatment device including a vacuum chamber internally kept in vacuum, and a positive electrode and a negative electrode disposed inside of the vacuum chamber, and having at least a part of a cooling channel formed in at least either of the positive electrode or the negative electrode, i.e. the cooled electrode;
performing a PVD treatment by producing discharges between the positive electrode and the negative electrode to vaporize the negative electrode;
during the PVD treatment, cooling the cooled electrode by circulating a cooling medium through the cooling channel; and
reversing the circulation direction of the cooling medium.

2. The PVD treatment method according to claim 1, wherein, in the PVD treatment device, the cooling channel disposed in the cooled electrode is branched to a plurality of branched channels, and the cooled electrode is cooled by a flow of the cooling medium distributed into each of the plurality of branched channels.

3. The PVD treatment method according to claim 1, wherein the PVD treatment is performed by a batch treatment, and the circulation direction of the cooling medium in the cooling channel is reversed for the each batch treatment.

4. The PVD treatment method according to claim 1, wherein a service life of the negative electrode is divided into a plurality of periods, and the circulation direction of the cooling medium in the cooling channel is reversed for the each divided period.

5. A PVD treatment device comprising:
a vacuum chamber internally kept in vacuum;
a positive electrode and a negative electrodes disposed inside of the vacuum chamber, the positive electrode and the negative electrode being capable of performing a PVD treatment by producing discharges between the positive electrode and the negative electrode to vaporize the negative electrode; and
a cooling mechanism for cooling at least either of the positive electrode or the negative electrode, i.e. the cooled electrode, the cooling mechanism including a cooling channel having a channel formed in the cooled electrode, through the inside of which a cooling medium can circulate for cooling the cooled electrode, and a circulation direction switching unit for alternately reversing the circulation direction of the cooling medium in the cooling channel.

6. The PVD treatment device according to claim 5, wherein the cooling channel includes a first cooling channel for cooling the cooled electrode by circulating the cooling medium from the one side to the other side of the cooled electrode, and a second cooling channel for cooling the electrode by circulating the cooling medium from the other side to the one side of the electrode, and the circulation direction switching unit switches between the first cooling channel and the second cooling channel for the cooling medium to circulate.

7. The PVD treatment device according to claim 5, wherein at least the positive electrode is the cooled electrode among the positive electrode and the negative electrode, the negative electrode is formed in a cylindrical shape extending in the vertical direction, the positive electrode includes an upper ring-shaped electrode disposed above the upper end of the negative electrode with a distance towards outside in the radial direction of the negative electrode, a lower ring-shaped electrode disposed below the lower end of the negative electrode with a distance towards outside in the radial direction of the negative electrode, and a plurality of rod-shaped electrodes connecting the upper ring-shaped electrode and lower ring-shaped electrode in the vertical direction, and the cooling channel includes an upper hollow part in a ring shape formed inside of the upper ring-shaped electrode, a lower hollow part in a ring shape formed inside of the lower ring-shaped electrode, and a plurality of middle hollow parts formed along the axis of each of the rod-shaped electrodes to communicate the upper hollow part and the lower hollow part.
